# EUROPEAN PATENT SPECIFICATION

(11) **EP 4 311 068 B1**
(45) Date of publication and mention of the grant of the patent: **30.04.2025**
(21) Application number: 22216444.4
(22) Date of filing: 23.12.2022
(51) Int. Cl.: H02J 7/00

(54) **DEVICE FOR MANAGING BATTERY AND METHOD OF OPERATING SAME**
VORRICHTUNG ZUR VERWALTUNG EINER BATTERIE UND VERFAHREN ZUM BETRIEB DAVON
DISPOSITIF DE GESTION DE BATTERIE ET SON PROCÉDÉ DE FONCTIONNEMENT

(30) Priority: 19.07.2022 KR 20220088929
(43) Date of publication of application: 24.01.2024
(73) Proprietor: Hyundai Mobis Co., Ltd., Gangnam-gu Seoul 06141 (KR)
(72) Inventor: LEE, Si Kwang, Gyeonggi-do (KR)
(74) Representative: Vossius & Partner Patentanwälte Rechtsanwälte mbB

(56) References cited:
- KR-A- 20200 025 944
- US-A1- 2011 254 514
- US-A1- 2021 313 815

## Description

### BACKGROUND

### FIELD

The present disclosure relates to a device for managing a battery and a method of operating the device and, more particularly, to a wakeup technique performed by a management device connected to a battery.

### DISCUSSION OF THE BACKGROUND

A battery is a device that stores electric energy, and is employed, as a power supply device, in various electronic apparatuses. A multiplicity of high-capacity batteries are mounted in electric vehicles. A multiplicity of integrated circuits (IC) may be used in such a manner as to monitor operation of the battery, a state thereof, or the like and to perform normal operation of the battery. These IC devices themselves may constitute a device for managing a battery or may be configured as at least one constituent element of the device for managing the battery.

For example, a multiplicity of semiconductor devices (sensing ICs) for monitoring the state of the battery are used. These sensing ICs are directly connected to the battery. These sensing ICs are kept connected to the battery and is supplied with electric power from the battery, unless they are physically disconnected from the battery. ICs, such as these sensing ICs, are kept connected to the battery even in a state where a vehicle stops driving. Thus, the ICs consume electric power of the battery. Therefore, the ICs are configured in such a manner that they enter a sleep mode and stand by in the state where the vehicle stop driving.

The IC is configured in such a manner that, in the case where the sleep mode is entered, when the vehicle restarts to drive, in order to wake up, the IC monitors a signal with a specific pattern that is input into a specific pin of the IC from the outside of the IC (for example, other electronic devices that include an ECU and the like). A problem with this technique is that electric power is always consumed in order to operate a communication signal monitoring block inside the IC.

In recent years, a voltage level of the battery that is required of an electric vehicle has been gradually increased (from 400 V to 800 V). Accordingly, the number of the ICs for managing the battery has been gradually increased. A reduction in consumption of electric power by the ICs is evaluated as a more important factor for managing the battery.

The background art of the present disclosure is disclosed in Korean Patent Application Publication Mo. 10-2020-0025944 (published on March 10, 2020). Further prior art can be found in US2021/313815 A1.

### SUMMARY

The invention is defined by the claims 1-10. An object of the present disclosure, which is made to solve the above-mentioned problem with a device for managing a battery in the related art, is to provide a device for managing a battery and a method of operating the device for managing a battery, the device and the method being capable of not only reducing consumption of standby electric power in a sleep mode for the device for managing a battery, but also performing a wakeup operation through a specific signal that is input from the outside.

According to an aspect of the present disclosure, there is provided a device for managing a battery, the device including: a battery cell input terminal connected to a battery and supplied with electric power; a communication signal input terminal through which a communication signal is input from the outside; a regulator unit configured to convert electric power input from the battery into electric power that is used inside a device for managing a battery, and to provide the resulting electric power; an electric power line including at least one switch that is turned off in a sleep mode for the device for managing a battery and connecting between the battery cell input terminal and the regulator unit; and a charge pump configured to output a voltage for turning on the switch using a signal that is input through the communication signal input terminal.

In the device, the electric power line may include: a line for electric power to be pre-supplied, the line including a switch that is turned on by the charge pump; and a main electric power line including a switch that is turned on according to operation of the regulator unit due to the pre-supplied electric power.

In the device, the line for electric power to be pre-supplied may include: a first switch connected to the charge pump and turned on by the charge pump; and a second switch arranged between the battery cell input terminal and the regulator unit and turned on when the first switch is turned on.

In the device, when the electric power to be pre-supplied is input through the line for electric power to be pre-supplied and when a frequency of a signal that is input through the communication signal input terminal corresponds to a preset frequency, the regulator unit may convert the electric power to be pre-supplied into electric power that is used inside the device for managing a battery, and may output the resulting electric power.

In the device, when the electric power that is used inside the device for managing a battery is supplied by the regulator unit, the device for managing a battery may turn on the switch of the main electric power line and thus may supply electric power to the regulator unit through the main electric power line.

In the device, when main electric power is input through the main electric power line, the regulator unit may convert the main electric power into the electric power that is used inside the device for managing a battery, and may output the resulting electric power.

In the device, the device for managing a battery may determine whether or not a signal that is input through the communication signal input terminal is a wakeup signal, and may turn on the switch of the main electric power line when the input signal is the wakeup signal.

In the device, the charge pump may output a voltage that is amplified using the signal that is input through the communication signal input terminal.

In the device, the signal that is input through the communication signal input terminal may be a differential signal.

According to another aspect of the present disclosure, there is provided a method of operating a device for managing a battery, the method including: checking a frequency of a signal that is input into a communication signal input terminal, when electric power to be pre-supplied is input through a line for electric power to be pre-supplied between a battery and a regulator; converting the electric power to be pre-supplied into electric power that is used inside a device for managing a battery, when the signal that is input into the communication signal input terminal corresponds to a preset frequency; and converting main electric power into the electric power that is used inside the device for managing a battery, when the main electric power is input through a main electric power line between the battery and the regulator after a preset standby time elapses.

In the method, the line for electric power to be pre-supplied may include at least one switch that is turned off in a sleep mode for the device for managing a battery and may be turned on according to the signal that is input into the communication signal input terminal.

In the method, the main electric power line may include at least one switch that is turned off in a sleep mode for the device for managing a battery and is turned on according to operation of the device for managing a battery due to the electric power to be pre-supplied.

In the device for managing a battery and the method of operating the device for managing a battery according to the present disclosure, the electric power line between the battery and the regulator of the device for managing a battery is configured in such a manner as to be switchable, but, for connection, is switched by amplifying and utilizing the wakeup signal that is input from the outside. Thus, the device and the method according to the present disclosure provide the effect of not only reducing consumption of standby electric power in the sleep mode for the device for managing a battery, but also performing the wakeup operation through the signal that is output from the outside.

In addition, in the device for managing a battery and the method of operating the device for managing a battery according to the present disclosure, the electric power line is configured to include the line for electric power to be pre-supplied and the main electric power line. Thus, the device and the method according to the present disclosure provide the effect of not only starting to operate the device for managing a battery due to the wakeup signal, but also making it possible to stably supply electric power after performing the wakeup operation.

### BRIEF DESCRIPTION OF THE DRAWINGS

FIG. 1 is a block diagram illustrating a configuration of a device for managing a battery according to a first embodiment of the present disclosure.
FIGS. 2 and 3 are views that are referred to for description of inputting of a wakeup signal for the device for managing a battery according to the first embodiment of the present disclosure.
FIG. 4 is a view that is referred to for description of a charge pump of the device for managing a battery according to the first embodiment of the present disclosure.
FIG. 5 is a flowchart that is referred to for description of a method of operating the device for managing a battery according to a second embodiment of the present disclosure.

### DETAILED DESCRIPTION OF THE ILLUSTRATED EMBODIMENTS

A device for managing a battery and a method of operating the device for managing a battery according to embodiments of the present disclosure will be described below with reference to the accompanying drawings. For clarity and convenience in description, thicknesses of lines, sizes of constituent elements, and the like may be illustrated in non-exact proportion in the drawings. In addition, a term defined by considering a function of a constituent element according to the present disclosure to which the term is assigned will be used below and may vary according to a user's or manager's intention or to practices in the art. Therefore, the term should be defined in context in light of the present specification.

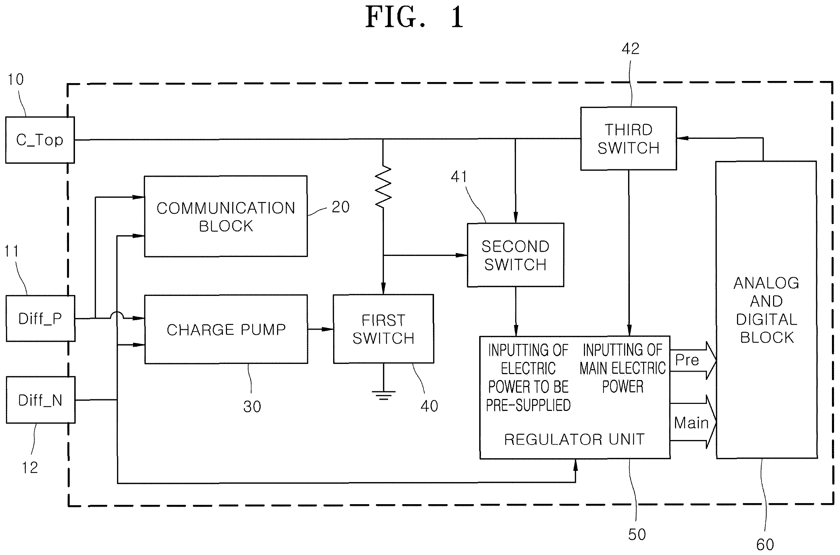

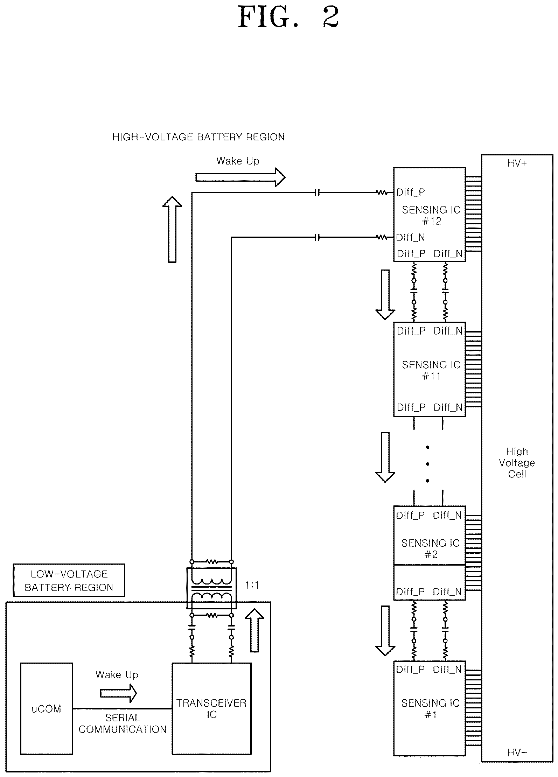

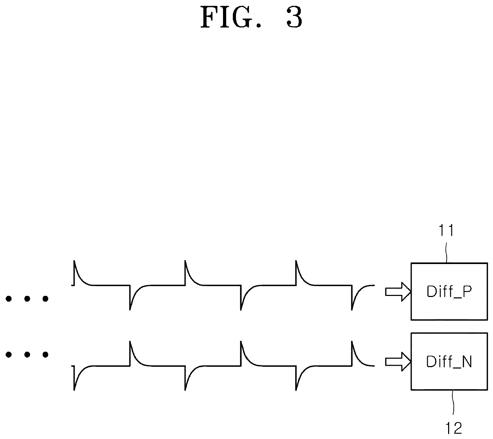

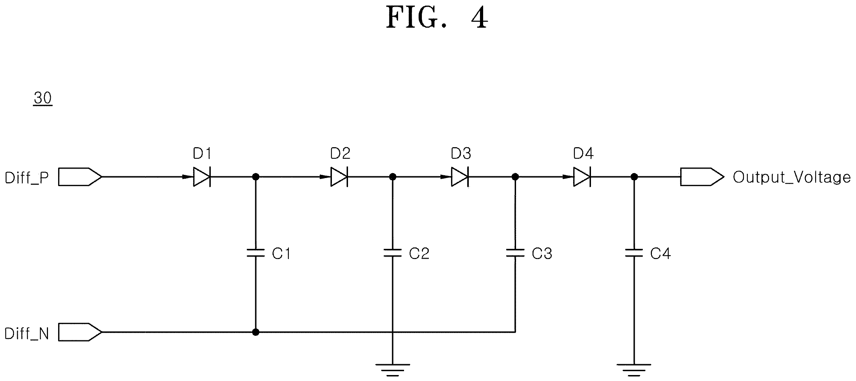

FIG. 1 is a block diagram illustrating a configuration of a device for managing a battery according to a first embodiment of the present disclosure. FIGS. 2 and 3 are views that are referred to for description of inputting of a wakeup signal for the device for managing a battery according to the first embodiment of the present disclosure. FIG. 4 is a view that is referred to for description of a charge pump of the device for managing a battery according to the first embodiment of the present disclosure. The device for managing a battery according to the first embodiment of the present disclosure will be described as follows with reference to FIGS. 1 to 4.

As illustrated in FIG. 1, the device for managing a battery according to the first embodiment of the present disclosure is an integrated circuit that is configured as a package that includes a multiplicity of elements, a semiconductor block, electric circuits, and the like inside. For example, the device for managing a battery may be a sensing IC that monitors a state (voltage, current, or the like) of a battery.

The device for managing a battery according to the first embodiment of the present disclosure includes terminals(such as pins), for connection to the outside. The device for managing a battery may at least include a battery cell input pin 10 that is connected to an IC, a differential signal positive signal input pin 11 for communication with the IC, and a differential signal negative signal input pin 12 for the communication with the IC. That is, the IC may be supplied with electric power from the battery connected to the battery cell input pin 10, and a communication signal may be input into the IC from the outside (for example, electronic devices of a vehicle that include an ECU and the like) of the IC through the two communication signal input pins 11 and 12. However, in one or several practical examples of the present disclosure, the number of the communication signal input pins is not limited to 2 and may be any other number (for example, 1 or 3).

The device for managing a battery according to the first embodiment of the present disclosure may include a communication block 20, a charge pump 30, switching units 40, 41, and 42, a regulator unit 50, and an analog and digital block 60.

The communication block 20 is a constituent element that transmits and receives a communication signal that is input from the outside of the IC. For example, the communication block 20 may be configured as a communication element that is capable of transmitting and receiving a differential signal.

The regulator unit 50 is a constituent element that is connected to the battery cell input pin 10, converts electric power input from the battery into electric power that is used inside the IC (that is, in the communication block 20, the analogy and digital block 60, and the like), and provides the resulting electric power. The regulator unit 50 may be configured to include a low-dropout (LDO) regulator, a controller that controls operation of the LDO regulator, and the like. However, the regulator and the controller may be configured as one individual physical element and may be configured as an element or the like that operates as a regulator when a preset specific condition is satisfied.

Conceptually, the analog and digital block 60 collectively refers to a multiplicity of individual elements for operation of the IC. Various types of individual elements (an analogy digital converter, a controller, and the like) for performing a function of the IC may be included in the analog and digital block 60.

According to the present disclosure, the supplying of electric power to the analog and digital block 60 by the regulator unit 50 means the supplying of electric power to various individual elements inside the IC by the regulator unit 50.

Although not illustrated in FIG. 1, the analog and digital block 60 may be connected to the communication block 20, and the communication block 20 may also be connected to the regulator unit 50 and thus be supplied with electric power from the regulator unit 50. It would be obvious to a person of ordinary skill in the art to which the present disclosure pertains that in addition, additional pins and various elements may be further included in the IC for the operation of the IC. Operation and a configuration of the IC, except for wakeup operation of the IC and a technique of supplying electric power to inside the IC that are described according to the present disclosure, may be the same as operation and a configuration, respectively, of a usual IC in the related art, and therefore, more detailed descriptions thereof are omitted.

The charge pump 30 boosts the wakeup signal that is input through the communication signal input pins 11 and 12, and thus, switches of the switching units 40, 41, and 42 may be turned on.

The switching units 40, 41, and 42 are arranged between the battery cell input pin 10 and the regulator unit 50. The switching units 40, 41, and 42 may switch between a connection between the battery cell input pin 10 and the regulator unit 50 (that is, a connection between the battery and the regulator unit 50) and a disconnection therefrom.

Two electric power lines (a line for electric power to be pre-supplied and a main electric power line) are configured for the connection between the battery cell input pin 10 and the regulator unit 50.

The line for electric power to be pre-supplied may include at least one switch. The pre-supply electric power line may be configured in such a manner as to be turned on with a voltage supplied from the charge pump 30 and thus as to establish the connection between the battery cell input pin 10 and the regulator unit 50. For example, the switch of the line for electric power to be pre-supplied may be configured to include an NPN (N channel) transistor 40 connected to the charge pump 30 and an PNP (P channel) transistor 41 connected between the battery cell input pin 10 and the regulator unit 50.

As illustrated in FIG. 2, the wakeup signal is input from the outside of the IC through the communication signal input pins 11 and 12, and, for example, may be a differential signal in a form as illustrated in FIG. 3.

The charge pump 30, as illustrated in FIG. 4, may output a maximum voltage of 3 x 5 V = 15 V when a differential signal of 5 V is input thereinto, and the resulting maximum voltage is input into a first switch 40 that is turned off. Thus, the first switch 40 is turned on. When the first switch 40 is turned on, accordingly, a second switch 41 is also turned on. Accordingly, the battery cell input pin 10 is connected to the regulator unit 50, and thus, a battery voltage is input.

When electric power is pre-input, the regulator unit 50 (the controller of the regulator unit 50) may check a communication signal from the outside and thus may determine whether or not the communication signal corresponds to noise or the like. For example, only in a case where a signal at a preset specific frequency is input, the regulator unit 50 determines that the input signal may correspond to the wakeup signal. Then, the regulator unit 50 generates electric power (electric power to be pre-supplied) necessary inside the IC, through the regulator and supplies the generated electric power to the analog and digital block 60 and the communication block 20.

That is, according to the first embodiment of the present disclosure, in a sleep mode for the device for managing a battery, the connection between the battery and the regulator is basically made not to be established and, thus consumption of dark current does not occur. Moreover, electric power is input into the IC through switching due to the wakeup signal, and thus the IC starts to operate. This provides an advantage in that in the sleep mode, there is no need to supply electric power to the communication block 20.

Like main electric power, electric power to be pre-supplied is electric power for temporary operation of the IC. Therefore, the regulator unit 50 may be configured to quickly check only a frequency of the communication signal and to determine only whether or not the communication signal is noise.

At this point, the regulator unit 50 may be configured to check frequencies of both of the two communication signal input pins 11 and 12 or to check the frequency of one of the two communication signal input pins 11 and 12. That is, FIG. 1 illustrates that a signal of one communication signal input pin 12 is input. However, a signal of the other communication signal input pin 11 may be input, or both of the two communication signal input pins 11 and 12 may be input.

When the communication block 20 is in an idle state (when the communication block 20 does not perform communication), a signal that is toggled is not input into the communication signal input pins 11 and 12. Therefore, the first switch 40 and the second switch 41 are kept turned off, and thus electric power cannot be pre-generated.

Accordingly, according to the present disclosure, the main electric power line may be separately configured, and thus electric power may be smoothly supplied after wakeup.

The main electric power line may include at least one switch and may be configured to be turned on by the analog and digital block 60 and to establish the connection between the battery cell input pin 10 and the regulator unit 50. For example, the switch of the main electric power line may be configured as a PNP (P channel) transistor 42, connected between the battery cell input pin 10 and the regulator unit 50.

Electric power is pre-input into the analog and digital block 60, and the analog and digital block 60 determines whether or not a signal that is input into the communication signal input pins 11 and 12 corresponds to the wakeup signal. In a case where the signal corresponds to the wakeup signal, the analog and digital block 60 may turn on a third switch 42 and thus may establish the main electric power line between the battery cell input pin 10 and the regulator unit 50. For example, the analog and digital block 60 may convert the input signal into a digital signal, may interpret the resulting digital signal, and may determine whether or not the input signal is the wakeup signal. However, with the operation and the configuration of the usual IC in the related art, it is also determined whether or not the received signal is the wakeup signal, and therefore, a more detailed description is omitted.

When the main electric power is input into the regulator unit 50, the regulator unit 50 generates electric power (the main electric power), necessary inside the IC, through the regulator and supplies the generated electric power to the analog and digital block 60. The analog and digital block 60 may keep the third switch 42 turned on and thus may keep the main electric power line connected while the IC operates.

When the main electric power is not input into the regulator unit 50, the regulator unit 50 may disable the regulator and thus may end temporary operation of the regulator due to a signal or the like other than the wakeup signal. At this point, after a preset standby time (for example, 100 µs) elapses, the regulator unit 50 may recognize whether or not the main electric power is input.

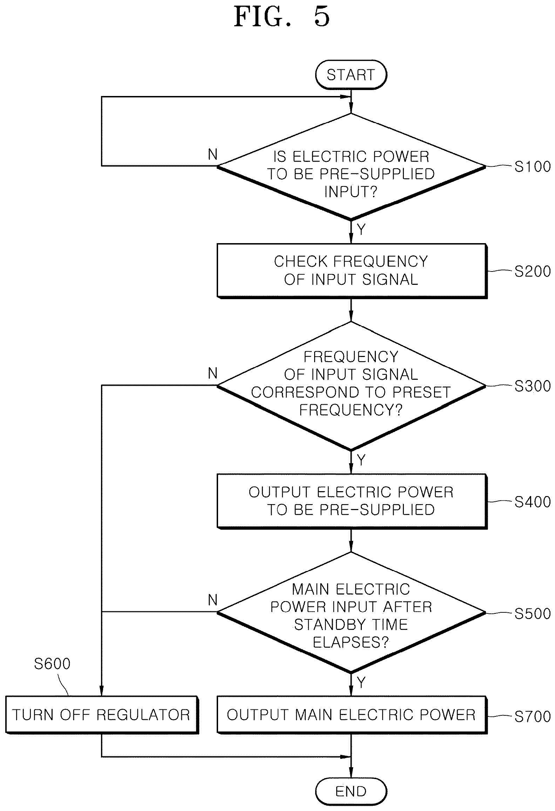

FIG. 5 is a flowchart that is referred to for description of a method of operating the device for managing a battery according to a second embodiment of the present disclosure.

As illustrated in FIG. 5, when electric power is pre-input by turning on the switch of the line for electric power to be pre-supplied (YES in S100), the controller of the regulator unit 50 checks the frequency of the signal that is input into the communication signal input pins 11 and 12 (S200).

In a case where the signal that is input into the communication signal input pins 11 and 12 corresponds to a preset frequency (YES in S300), the controller generates electric power (electric power to be pre-supplied), necessary inside the IC, through the regulator, outputs the generated electric power, and supplies the generated electric power to inside the IC (S400).

Subsequently, when the main electric power is being input after the preset standby time elapses (YES in S500), the controller generates electric power (the main electric power), necessary inside the IC, through the regulator, outputs the generated electric power, and supplies the generated electric power to inside the IC (S700).

When the signal that is input in the communication signal input pins 11 and 12 does not correspond to the preset frequency in Step S300, or when in Step S500, the main electric power is not input after the standby time elapses, the controller may disable the regulator and may end temporary operation of the regulator due to a signal, noise, or the like other than the wakeup signal.

The device for managing a battery according to the first embodiment of the present disclosure and the method of operating the device for managing a battery according to the second embodiment of the present disclosure are configured in such a manner that the electric power line between the battery and the regulator of the device for managing a battery is switchable, and do not use the communication block in performing the wakeup operation. Thus, consumption of standby electric power in the sleep mode can be reduced.

In addition, the device for managing a battery according to the first embodiment of the present disclosure and the method of operating the device for managing a battery according to the second embodiment of the present disclosure switch the electric power line for being connected, by amplifying and utilizing the wakeup signal that is input from the outside. Thus, it is possible to perform the wakeup operation of the device for managing a battery that uses the wakeup signal in the related art.

In addition, in the device for managing a battery according to the first embodiment of the present disclosure and the method of operating the device for managing a battery according to the second embodiment of the present disclosure, the electric power line is configured to include the line for electric power to be pre-supplied and the main electric power line. Thus, it is possible to stably supply electric power when the device for managing a battery starts to operate due to the wakeup signal and after the wakeup.

The embodiments of the present disclosure are described only in an exemplary manner with reference to the drawings. It would be understandable to a person of ordinary skill in the art to which the present disclosure pertains that various modifications may possibly be made to the embodiments and that various equivalents thereof may possibly be implemented. Thus, the technical scope of the present disclosure should be defined by the following claims.

## Claims

1. A device for managing a battery, the device comprising:
a battery cell input terminal (10) connected to a battery and supplied with electric power;
a communication signal input terminal (11, 12) through which communication signal is input from the outside;
a regulator unit (50) configured to convert electric power input from the battery into electric power that is used inside a device for managing a battery, and to provide the resulting electric power;
an electric power line comprising at least one switch (40, 41, 42) that is turned off in a sleep mode for the device for managing a battery and connecting between the battery cell input terminal (10) and the regulator unit (50); and
a charge pump (30) configured to output a voltage for turning on the switch (40, 41, 42) using a signal that is input through the communication signal input terminal (11, 12);
**characterized in that**
the electric power line comprises:
a line for electric power to be pre-supplied, the line comprising a first switch (40) connected to the charge pump (30) and turned on by the charge pump (30); and
a main electric power line comprising a third switch (42) that is turned on according to operation of the regulator unit (50) due to the pre-supplied electric power.

2. The device of claim 1, wherein the line for electric power to be pre-supplied comprises:
a second switch (41) arranged between the battery cell input terminal (10) and the regulator unit (50) and turned on when the first switch (40) is turned on.

3. The device of any of claim 1 or 2, wherein, when the electric power to be pre-supplied is input through the line for electric power to be pre-supplied and when a frequency of a signal that is input through the communication signal input terminal (11, 12) corresponds to a preset frequency, the regulator unit (50) is configured to convert the electric power to be pre-supplied into electric power that is used inside the device for managing a battery, and is configured to output the resulting electric power.

4. The device of any of the preceding claims, wherein, when the electric power that is used inside the device for managing a battery is supplied by the regulator unit (50), the device for managing a battery turns on the switch (40, 41, 42) of the main electric power line and thus supplies electric power to the regulator unit (50) through the main electric power line.

5. The device of any of the preceding claims, wherein, when main electric power is input through the main electric power line, the regulator unit (50) is configured to convert the main electric power into the electric power that is used inside the device for managing a battery, and is configured to output the resulting electric power.

6. The device of any of the preceding claims, wherein the device for managing a battery determines whether or not a signal that is input through the communication signal input terminal (11, 12) is a wakeup signal, and turns on the switch (40, 41, 42) of the main electric power line when the input signal is the wakeup signal.

7. The device of any of the preceding claims, wherein the charge pump (30) outputs a voltage that is amplified using the signal that is input through the communication signal input terminal (11, 12).

8. The device of any of the preceding claims, wherein the signal that is input through the communication signal input terminal (11, 12) is a differential signal.

9. A method of operating a device for managing a battery,
the method comprising:
supplying electric power to a battery cell input terminal (10) connected to a battery,
turning off at least one switch (10, 41, 41) of an electric power line in a sleep mode for the device for managing a battery and connecting between the battery cell input terminal (10) and the regulator unit (50),
pre-supplying electric power to a line comprised in the electric power line, wherein the line comprises a first switch (40) connected to a charge pump (30) and turned on by the charge pump (30),
turning on a third switch (42) comprised in a main electric power line comprised in the electric power line according to the operation of the regulator unit due to the pre-supplied electric power,
inputting, via a communication signal input terminal (11, 12), communication signal from the outside;
converting, via the regulator unit (50), electric power input from the battery into electric power that is used inside the device for managing a battery and providing the resulting electric power;
outputting, via the charge pump (30), a voltage for turning on the switch (40, 41, 42) using a signal that is input through the communication signal input terminal (11, 12).

10. The method of claim 9, further comprising:
checking a frequency of a signal that is input into the communication signal input terminal (11, 12), when electric power to be pre-supplied is input through the line for electric power to be pre-supplied between the battery and a regulator;
converting the electric power to be pre-supplied into electric power that is used inside a device for managing the battery, when the signal that is input into the communication signal input terminal (11, 12) corresponds to a preset frequency; and
converting main electric power into the electric power that is used inside the device for managing a battery, when the main electric power is input through a main electric power line between the battery and the regulator after a preset standby time elapses.

## Patentansprüche

1. Vorrichtung zur Verwaltung einer Batterie, wobei die Vorrichtung aufweist:
einen Batteriezellen-Eingangsanschluss (10), der mit einer Batterie verbunden ist und mit elektrischer Leistung versorgt wird;
einen Kommunikationssignal-Eingangsanschluss (11, 12), durch den von außen ein Kommunikationssignal eingespeist wird;
eine Reglereinheit (50), die konfiguriert ist, um von der Batterie eingespeiste elektrische Leistung in elektrische Leistung umzuwandeln, die innerhalb einer Vorrichtung zur Verwaltung einer Batterie verwendet wird, und um die sich ergebende elektrische Leistung bereitzustellen;
eine Starkstromleitung, die wenigstens einen Schalter (40, 41, 42) aufweist, der in einer Ruhebetriebsart für die Vorrichtung zur Verwaltung einer Batterie ausgeschaltet ist und zwischen dem Batteriezellen-Eingangsanschluss (10) und der Reglereinheit (50) verbunden ist; und
eine Ladungspumpe (30), die konfiguriert ist, um unter Verwendung eines Signals, das durch den Kommunikationssignal-Eingangsanschluss (11, 12) eingespeist wird, eine Spannung zum Einschalten des Schalters (40, 41, 42) auszugeben;
**dadurch gekennzeichnet, dass**
die Starkstromleitung aufweist:
eine Leitung für elektrische Leistung, die vorab bereitgestellt werden soll, wobei die Leitung einen mit der Ladungspumpe (30) verbundenen ersten Schalter (40), der von der Ladungspumpe (30) eingeschaltet wird, aufweist; und
eine Hauptstromleitung, die einen dritten Schalter (42) aufweist, der gemäß einem Betrieb der Reglereinheit (50) aufgrund der vorab bereitgestellten elektrischen Leistung eingeschaltet wird.

2. Vorrichtung nach Anspruch 1, wobei die Leitung für elektrische Leistung, die vorab bereitgestellt werden soll, aufweist:
einen zweiten Schalter (41), der zwischen dem Batteriezellen-Eingangsanschluss (10) und der Reglereinheit (50) angeordnet ist und eingeschaltet wird, wenn der erste Schalter (40) eingeschaltet wird.

3. Vorrichtung nach Anspruch 1 oder 2, wobei die Reglereinheit (50) konfiguriert ist, um die elektrische Leistung, die vorab bereitgestellt werden soll, in elektrische Leistung umzuwandeln, die innerhalb der Vorrichtung zur Verwaltung einer Batterie verwendet wird, und konfiguriert ist, um die sich ergebende elektrische Leistung auszugeben, wenn die elektrische Leistung, die vorab bereitgestellt werden soll, durch die Leitung für die elektrische Leistung, die vorab bereitgestellt werden soll, eingespeist wird und wenn eine Frequenz eines Signals, das durch den Kommunikationssignal-Eingangsanschluss (11, 12) eingespeist wird, einer vorab festgelegten Frequenz entspricht.

4. Vorrichtung nach einem der vorhergehenden Ansprüche, wobei die Vorrichtung zur Verwaltung einer Batterie, wenn die elektrische Leistung, die innerhalb der Vorrichtung zur Verwaltung einer Batterie verwendet wird, von der Reglereinheit (50) bereitgestellt wird, den Schalter (40, 41, 42) der Hauptstromleitung einschaltet und somit durch die Hauptstromleitung elektrische Leistung an die Reglereinheit (50) bereitstellt.

5. Vorrichtung nach einem der vorhergehenden Ansprüche, wobei die Reglereinheit (50) konfiguriert ist, um den Hauptstrom in die elektrische Leistung, die innerhalb der Vorrichtung zur Verwaltung einer Batterie verwendet wird, umzuwandeln und konfiguriert ist, um die sich ergebende elektrische Leistung auszugeben, wenn der Hauptstrom durch die Hauptstromleitung eingespeist wird.

6. Vorrichtung nach einem der vorhergehenden Ansprüche, wobei die Vorrichtung zur Verwaltung einer Batterie bestimmt, ob ein durch den Kommunikationssignal-Eingangsanschluss (11, 12) eingespeistes Signal ein Wecksignal ist oder nicht, und den Schalter (40, 41, 42) der Hauptstromleistung einschaltet, wenn das Eingangssignal das Aufwecksignal ist.

7. Vorrichtung nach einem der vorhergehenden Ansprüche, wobei die Ladungspumpe (30) eine Spannung ausgibt, die unter Verwendung des durch den Kommunikationssignal-Eingangsanschluss (11, 12) eingespeisten Signals verstärkt wird.

8. Vorrichtung nach einem der vorhergehenden Ansprüche, wobei das durch den Kommunikationssignal-Eingangsanschluss (11, 12) eingespeiste Signal ein Differenzialsignal ist.

9. Verfahren für den Betrieb einer Vorrichtung zur Verwaltung einer Batterie, wobei das Verfahren aufweist:
Bereitstellen von elektrischer Leistung an einen mit einer Batterie verbundenen Batteriezellen-Eingangsanschluss (10),
Ausschalten von wenigstens einem Schalter (10, 41, 41) einer Starkstromleitung in einer Ruhebetriebsart für die Vorrichtung zur Verwaltung einer Batterie und Verbinden des Batteriezellen-Eingangsanschlusses (10) und der Reglereinheit (50),
vorab Bereitstellen von elektrischer Leistung an eine in der Starkstromleitung enthaltene Leitung, wobei die Leitung einen ersten Schalter (40), der mit einer Ladungspumpe (30) verbunden ist und von der Ladungspumpe (30) eingeschaltet wird, aufweist,
Einschalten eines dritten Schalters (42), der in einer in der Starkstromleitung enthaltenen Hauptstromleitung enthalten ist, gemäß dem Betrieb der Reglereinheit aufgrund der vorab bereitgestellten elektrischen Leistung;
Einspeisen eines Kommunikationssignals von außen über einen Kommunikationssignal-Eingangsanschluss (11, 12);
Umwandeln von elektrischer Leistung, die von der Batterie eingespeist wird, in elektrische Leistung, die innerhalb der Vorrichtung zur Verwaltung einer Batterie verwendet wird, und Bereitstellen der sich ergebenden elektrischen Leistung über die Reglereinheit (50);
Ausgeben einer Spannung zum Einschalten des Schalters (40, 41, 42) über die Ladungspumpe (30) unter Verwendung eines Signals, das durch den Kommunikationssignal-Eingangsanschluss (11, 12) eingespeist wird.

10. Verfahren nach Anspruch 9, das ferner aufweist:
Prüfen einer Frequenz eines Signals, das in den Kommunikationssignal-Eingangsanschluss (11, 12) eingespeist wird, wenn elektrische Leistung, die vorab bereitgestellt werden soll, durch die Leitung für die elektrische Leistung, die vorab bereitgestellt werden soll, zwischen der Batterie und einem Regler eingespeist wird;
Umwandeln der elektrischen Leistung, die vorab bereitgestellt werden soll, in elektrische Leistung, die innerhalb einer Vorrichtung zur Verwaltung einer Batterie verwendet wird, wenn das Signal, das in den Kommunikationssignal-Eingangsanschluss (11, 12) eingespeist wird, einer vorab festgelegten Frequenz entspricht; und
Umwandeln des Hauptstroms in die elektrische Leistung, die innerhalb der Vorrichtung zur Verwaltung einer Batterie verwendet wird, wenn der Hauptstrom durch eine Hauptstromleitung zwischen der Batterie und dem Regler eingespeist wird, nachdem eine vorab festgelegte Bereitschaftszeit vergangen ist.

## Revendications

1. Dispositif pour gérer une batterie, le dispositif comprenant :
une borne d'entrée d'élément de batterie (10) connectée à une batterie et alimentée en courant électrique ;
une borne d'entrée de signal de communication (11, 12) par l'intermédiaire de laquelle un signal de communication est entré depuis l'extérieur ;
une unité de régulateur (50) configurée pour convertir le courant électrique entré depuis la batterie en courant électrique qui est utilisé à l'intérieur d'un dispositif pour gérer une batterie, et pour fournir le courant électrique résultant ;
une ligne de courant électrique comprenant au moins un commutateur (40, 41, 42) qui est mis à l'arrêt dans un mode veille pour le dispositif pour gérer une batterie et réalisant une connexion entre la borne d'entrée d'élément de batterie (10) et l'unité régulatrice (50) ; et
une pompe de charge (30) configurée pour délivrer une tension pour mettre en marche le commutateur (40, 41, 42) au moyen d'un signal qui est entré par l'intermédiaire de la borne d'entrée de signal de communication (11, 12) ;
**caractérisé en ce que**
la ligne de courant électrique comprend :
une ligne pour le courant électrique à pré-fournir, la ligne comprenant un premier commutateur (40) connecté à la pompe de charge (30) et mis en marche par la pompe de charge (30) ; et
une ligne de courant électrique principal comprenant un troisième commutateur (42) qui est mis en marche en fonction de l'exploitation de l'unité régulatrice (50) en raison du courant électrique pré-fourni.

2. Dispositif selon la revendication 1, dans lequel la ligne pour le courant électrique à pré-fournir comprend :
un deuxième commutateur (41) agencé entre la borne d'entrée d'élément de batterie (10) et l'unité régulatrice (50) et mis en marche lorsque le premier commutateur (40) est mis en marche.

3. Dispositif selon l'une quelconque de la revendication 1 ou 2, dans lequel, lorsque le courant électrique à pré-fournir est entré par l'intermédiaire de la ligne pour le courant électrique à pré-fournir et lorsqu'une fréquence d'un signal qui est entré par l'intermédiaire de la borne d'entrée de signal de communication (11, 12) correspond à une fréquence prédéfinie, l'unité régulatrice (50) est configurée pour convertir le courant électrique à pré-fournir en courant électrique qui est utilisé à l'intérieur du dispositif pour gérer une batterie, et est configurée pour délivrer le courant électrique résultant.

4. Dispositif selon l'une quelconque des revendications précédentes, dans lequel, lorsque le courant électrique qui est utilisé à l'intérieur du dispositif pour gérer une batterie est fourni par l'unité régulatrice (50), le dispositif pour gérer une batterie met en marche le commutateur (40, 41, 42) de la ligne de courant électrique principal et fournit ainsi du courant électrique à l'unité régulatrice (50) par l'intermédiaire de la ligne de courant électrique principal.

5. Dispositif selon l'une quelconque des revendications précédentes, dans lequel, lorsque du courant électrique principal est entré par l'intermédiaire de la ligne de courant électrique principal, l'unité régulatrice (50) est configurée pour convertir le courant électrique principal en courant électrique qui est utilisé à l'intérieur du dispositif pour gérer une batterie, et est configurée pour délivrer le courant électrique résultant.

6. Dispositif selon l'une quelconque des revendications précédentes, dans lequel le dispositif pour gérer une batterie détermine si un signal qui est entré par l'intermédiaire de la borne d'entrée de signal de communication (11, 12) est un signal de sortie de veille ou non, et met en marche le commutateur (40, 41, 42) de la ligne de courant électrique principal lorsque le signal entré est le signal de sortie de veille.

7. Dispositif selon l'une quelconque des revendications précédentes, dans lequel la pompe de charge (30) délivre une tension qui est amplifiée au moyen du signal qui est entré par l'intermédiaire de la borne d'entrée de signal de communication (11, 12).

8. Dispositif selon l'une quelconque des revendications précédentes, dans lequel le signal qui est entré par l'intermédiaire de la borne d'entrée de signal de communication (11, 12) est un signal différentiel.

9. Procédé d'exploitation d'un dispositif pour gérer une batterie, le procédé comprenant :
la fourniture de courant électrique à une borne d'entrée d'élément de batterie (10) connectée à une batterie,
la mise à l'arrêt d'au moins un commutateur (10, 41, 41) d'une ligne de courant électrique dans un mode veille pour le dispositif pour gérer une batterie et la réalisation d'une connexion entre la borne d'entrée d'élément de batterie (10) et l'unité régulatrice (50),
la pré-fourniture de courant électrique à une ligne comprise dans la ligne de courant électrique, dans lequel la ligne comprend un premier commutateur (40) connecté à une pompe de charge (30) et mis en marche par la pompe de charge (30),
la mise en marche d'un troisième commutateur (42) compris dans une ligne de courant électrique principal comprise dans la ligne de courant électrique en fonction de l'exploitation de l'unité régulatrice en raison du courant électrique pré-fourni,
l'entrée, par le biais d'une borne d'entrée de signal de communication (11, 12), d'un signal de communication depuis l'extérieur ;
la conversion, par le biais de l'unité régulatrice (50), du courant électrique entré depuis la batterie en courant électrique qui est utilisé à l'intérieur du dispositif pour gérer une batterie et la fourniture du courant électrique résultant ;
la sortie, par le biais de la pompe de charge (30), d'une tension pour mettre en marche le commutateur (40, 41, 42) au moyen d'un signal qui est entré par l'intermédiaire de la borne d'entrée de signal de communication (11, 12).

10. Procédé selon la revendication 9, comprenant en outre :
la vérification d'une fréquence d'un signal qui est entré dans la borne d'entrée de signal de communication (11, 12), lorsque du courant électrique à pré-fournir est entré par l'intermédiaire de la ligne pour le courant électrique à pré-fournir entre la batterie et un régulateur ;
la conversion du courant électrique à pré-fournir en courant électrique qui est utilisé à l'intérieur d'un dispositif pour gérer la batterie, lorsque le signal qui est entré dans la borne d'entrée de signal de communication (11, 12) correspond à une fréquence prédéfinie ; et
la conversion du courant électrique principal en le courant électrique qui est utilisé à l'intérieur du dispositif pour gérer une batterie, lorsque le courant électrique principal est entré par l'intermédiaire d'une ligne de courant électrique principal entre la batterie et le régulateur après qu'un temps d'attente prédéfini s'est écoulé.
